# EUROPEAN PATENT APPLICATION

(11) **EP 4 439 629 A1**
(43) Date of publication of application: **02.10.2024**
(21) Application number: 24167194.0
(22) Date of filing: 28.03.2024
(51) Int. Cl.: H01L 21/02, H01L 21/18, H01L 21/762

(54) **LOW RESISTIVITY POLYCRYSTALLINE BASED SUBSTRATE OR WAFER**

(30) Priority: 31.03.2023 SE 2350379
(71) Applicant: STMicroelectronics International N.V., 1228 Plan-les-Ouates, Geneva (CH)
(72) Inventor: MAGNUSSON LINDGREN, Björn, 60379 NORRKÖPING (SE); RIVA, Carlo, 20838 RENATE (MB) (IT)
(74) Representative: Studio Torta S.p.A.

(57) **Abstract**

A semiconductor device comprises a polycrystalline silicon carbide -SiC- layer or base substrate (106). The polycrystalline silicon carbide layer has a resistivity less than or equal to (2) mohm·cm such that the polycrystalline silicon carbide layer (106) is a low resistivity polycrystalline silicon carbide layer. The polycrystalline silicon carbide layer (106) may have grains with a grain size less than or equal to 1 mm, and may have a non-columnar structure. The polycrystalline silicon carbide layer may have a warpage less than or equal to 75 µm. A monocrystalline silicon carbide layer (106)is coupled to the polycrystalline silicon carbide (110) layer by a bonding region (108). The monocrystalline silicon carbide layer may be thinner than the polycrystalline silicon carbide layer.

## Description

### TECHNICAL FIELD

The present disclosure is directed to silicon carbide based substrates and wafers with a low resistivity and low warpage.

### BACKGROUND

The semiconductor industry has been showing considerable interest in silicon carbide (SiC), in particular for the manufacture of electronic devices or components (*e.g*., diodes, transistors, or other similar power applications).

Generally, silicon carbide wafers are polycrystalline SiC wafers which may be manufactured by bonding a single crystal wafter on the polycrystalline SiC wafer. For example, there is a wafer manufacturing method in which the polycrystalline SiC wafer and the single crystal SiC wafer are bonded and integrated together by direct bonding.

Development and manufacture of silicon carbide based electronic devices are limited by factors such as electrical and mechanical properties from forming silicon carbide wafers. Many manufactured silicon carbide wafers have a resistivity greater than is beneficial for the final products. Another issue is an amount of warpage that comes from the manufacturing of the wafer. A higher resistivity limits an ability of an electrical signal to travel through the silicon carbide wafer. A higher amount of warpage results in defects when manufacturing the end electronic devices, such as from the polishing processes, or results in an increase in a number of cracked or broken wafers or substrates during processing and manufacturing.

In a power device, these crystal defects, high resistivity, and high warpage may be problematic as these factors limit the functionality of the power device such that the power device functions outside of selected tolerances. In such situations, these devices may be disposed of (*e.g*., thrown out), which increases manufacturing costs due to a decrease in yield.

Accordingly, an aim of the present invention is to devise a solution that solves the above issues.

### SUMMARY

According to the invention, a device including a silicon carbide based substrate and a process for manufacturing a device including a silicon carbide based substrate are provided, as defined in the attached claims.

### BRIEF DESCRIPTION OF THE DRAWINGS

For a better understanding of the invention, reference will now be made by way of example to the accompanying drawings, wherein:
Figure 1 is a perspective side view of an embodiment of a wafer;
Figure 2 is a perspective side view of an alternative embodiment of a wafer;
Figure 3 is a perspective side view of an embodiment of a polycrystalline layer or substrate utilized in the embodiment of the wafer as shown in Figure 1 or utilized within the alternative embodiment of the wafer as shown in Figure 2;
Figure 4 is a zoomed in enhanced view of section 4-4 as shown in Figure 1 of the wafer shown therein;
Figure 5A is a flowchart of a method of manufacturing the embodiment of the wafer as shown in Figure 1;
Figure 5B is a flowchart of an embodiment of a method of manufacturing the polycrystalline substrate as shown in Figure 3;
Figure 5C is a flowchart of an alternative embodiment of a method of manufacturing the polycrystalline substrate as shown in Figure 3;
Figure 5D is a flowchart of another alternative embodiment of a method of manufacturing the polycrystalline substrate as shown in Figure 3; and
Figures 6A-6C are side views of at least some of the steps of the method of manufacturing as shown in Figure 5A to manufacture the wafer as shown in Figure 1.

### DETAILED DESCRIPTION

In the following description, the sizes and relative positions of elements in the drawings are not necessarily drawn to scale. For example, the shapes of various elements and angles may not be drawn to scale, and some of these elements may be enlarged and positioned to improve drawing legibility.

Generally, polycrystalline silicon carbide (SiC) substrates, wafers, or layers have been utilized within various electronic devices and components (*e.g.*, semiconductor die, semiconductor packages, semiconductor transistors, etc.). These polycrystalline SiC substrates, wafers, or layers have a resistivity that results in a resistance being present along an electrical pathway that passes through or along the polycrystalline silicon carbide (SiC) substrate. This resistance impedes an electrical signal as it passes through or along the electrical pathway is known as an on-resistance (Rₒₙ). This on-resistance (Rₒₙ) of the polycrystalline SiC substrate limits an efficiency or electrical characteristics of the electronic devices made from the polycrystalline SiC substrates. For example, if the on-resistance (Rₒₙ) is high, the electrical signal may be impeded from fully passing through the polycrystalline SiC substrates to reach its destination resulting in functional errors within the electronic devices or components. In view of at least this on-resistance (Rₒₙ) issue with polycrystalline silicon carbide (SiC) substrates, wafers, or layers, the present polycrystalline silicon carbide (SiC) substrate, wafer, or layer has a resistivity less than resistivities of current polycrystalline silicon carbide (SiC) substrates. For example, a polycrystalline silicon carbide (SiC) substrate, wafer, or layer already utilized within these respective industries may have a resistivity that is within the range of 2 mohm·cm (milliohm-centimeter) to 10 mohm-cm (milliohm·centimeter).

A polycrystalline SiC wafer with a low resistivity benefits functionality of an electronic in which the polycrystalline SiC wafer is present. Here, a wafer is disclosed, including a polycrystalline silicon carbide wafer or substrate that has a low resistivity and a low warpage. Electronic devices or components made from the wafer are further optimized when in use and have fewer to no crystal defects. The described wafer has a low or very low resistivity as compared to existing SiC wafers.

The wafer includes a polycrystalline silicon carbide (SiC) wafer or substrate with a resistivity less than or equal to 2 mohm·cm (milliohm·centimeter) and a warpage less than or equal to 75 µm (micrometers). The wafer may include a bonding region between the polycrystalline silicon carbide (SiC) wafer and a monocrystalline silicon carbide (SiC) wafer that is coupled to the polycrystalline silicon carbide (SiC) wafer by the bonding region. The low resistivity (e.g., 2 mohm·cm) of the polycrystalline silicon carbide (SiC) wafer reduces the "on" resistance (Rₒₙ) when an electrical signal passes through the polycrystalline SiC wafer improving overall signal transportation functionality and efficiency of a power device that includes the wafer or a portion of the wafer. The low warpage (*e.g*., less than or equal to 75 µm) of the polycrystalline SiC wafer reduces the likelihood of or prevents mechanical or electrical defects within the bonding layer. The low warpage of the polycrystalline SiC wafer also reduces the likelihood of prevents mechanical or electrical defects between the bonding layer, the monocrystalline silicon carbide layer, and the polycrystalline silicon carbide layer.

The low amount of warpage in the wafer prevents or reduces the likelihood of defects when manufacturing the end electronic devices, such as from the polishing processes, or results in a decrease in a number of cracked or broken wafers or substrates during processing and manufacturing.

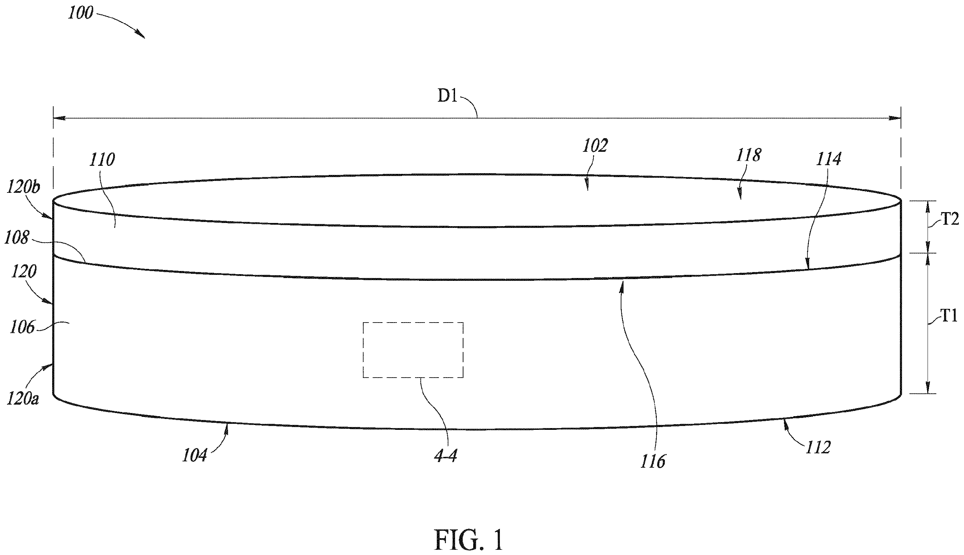

Figure 1 is a side view of a wafer 100. The wafer 100 includes a first side 102 and a second side 104 that is opposite to the first side 102. The wafer 100 further includes a polycrystalline silicon carbide (SiC) layer 106, a bonding region or layer 108, and a monocrystalline silicon carbide (SiC) layer 110 that is bonded to the polycrystalline silicon carbide layer 106 at the bonding region 108. The polycrystalline silicon carbide layer 106 may be referred to as a polycrystalline silicon carbide substrate, a polycrystalline silicon carbide wafer, a polycrystalline silicon carbide layer, or may be referred to in some other suitable manner. The monocrystalline silicon carbide (SiC) layer 110 may be referred to as a monocrystalline silicon carbide substrate, a monocrystalline silicon carbide wafer, a monocrystalline silicon carbide layer, or may be referred to in some other suitable manner. The polycrystalline silicon carbide (SiC) layer 106 may be referred to as a polycrystalline layer 106 herein within the present disclosure, and the monocrystalline silicon carbide (SiC) layer 110 may be referred to as a monocrystalline layer 110 herein within the present disclosure. In at least one embodiment, the monocrystalline layer 110 has a density equal to 3.26 g/cm³. In at least one embodiment, the polycrystalline layer 106 has a density within a range ranging from 3.2 g/cm³ to 3.3 g/cm³, or the density is equal to the upper and lower ends of this range. In at least one embodiment, the polycrystalline layer 106 has a density within a range ranging from 3.25 g/cm³ to 3.3 g/cm³, or the density is equal to the upper and lower ends of this range.

The polycrystalline layer 106 has a low resistivity, for example, a resistivity less than or equal to 2 mohm·cm (milliohm·centimeter) or a resistivity less than or equal to 1 mohm·cm (milliohm·centimeter). This low resistivity of the polycrystalline layer 106 allows for an electrical signal (*e.g*., electrons) to pass through the polycrystalline layer 106 without being impeded by the polycrystalline layer 106 such that the electrical signal may travel faster through the polycrystalline layer 106 and may reach its destination with a higher strength than when the polycrystalline layer 106 had a high resistivity. In other words, when the on-resistance (Rₒₙ) of the polycrystalline 106 is low (*i.e.,* low resistivity) the electrical signal will more readily and efficiently pass through the polycrystalline layer 106 without being impeded by the polycrystalline layer 106 when traveling to its destination within an electronic device (*e.g*., semiconductor package, semiconductor die, or some other similar or like electronic device in which the polycrystalline layer 106 may be present).

The polycrystalline layer 106 includes a first surface 112 and a second surface 114 opposite to the first surface 112. The first surface 112 of the polycrystalline layer 106 is at the first side 104 of the wafer 100. The monocrystalline layer 110 includes a third surface 116 and a fourth surface 118 opposite to the third surface 116. The fourth surface 118 of the monocrystalline layer 110 is at the second side 106 of the wafer 100.

The polycrystalline layer 106 has a first thickness T1, which may be referred to as a first dimension. The first thickness T1 extends from the first surface 112 of the polycrystalline layer 106 to the second surface 114 of the polycrystalline layer 106. In some embodiments, the first thickness T1 may be within the range 150-1500 micrometers (µm) or equal to the upper and lower ends of this range *(e.g.,* the first thickness T1 may be equal to 150 micrometers (µm) or may be equal to 1000 micrometers (µm)). In some embodiments, the first thickness may be less than or equal to 1 millimeter (mm).

The monocrystalline layer 110 has a second thickness T2, which may be referred to as a second dimension. The second thickness T2 extends from the third surface 116 of the monocrystalline layer 110 to the fourth surface 118 of the monocrystalline layer 110. The second thickness T2 of the monocrystalline layer 110 may be less than the first thickness T1 of the polycrystalline layer 106. The second thickness T2 of the monocrystalline layer 110 may be within the range 0.3-2 micrometers (µm) or equal to the upper and lower ends of this range (*e.g.,* the second thickness T2 may be equal to 0.3 micrometers (µm) or may be equal to 2 micrometer (µm)). In some embodiments, the second thickness may be within the range 0.3-1 micrometers (µm) or equal to the upper and lower ends of this range (*e.g.,* the second thickness T2 may be equal to 0.3 micrometers (µm) or may be equal to 1 micrometer (µm)). In some embodiments, the second thickness T2 of the monocrystalline layer 110 may be equal to 0.5 micrometers (µm). In some embodiments, the second thickness T2 may be less than or equal to 20-200 micrometers (µm) or equal to the upper and lower ends of this range (*e.g.,* the second thickness T2 may be equal to 20 micrometers (µm) or may be equal to 200 micrometers (µm)). In some embodiments, the second thickness T2 may be equal to 120 micrometers (µm).

In some embodiments, a sum of the first thickness T1 and the second thickness T2 may be within a range from 200 micrometers (µm) to 1500 micrometers (µm), or may be equal to the upper and lower ends of this range. For example, in some embodiments, the sum of first thickness T1 and the second thickness T2 may be equal to 200 micrometers (µm), may be equal to 1500 micrometers (µm), or may be equal to some other thickness between 200 and 1500 micrometers (µm). In some embodiments, the sum of the first thickness T1 and the second thickness T2 may be equal to 250 micrometers (µm), may be equal to 500 micrometers (µm), or may be equal to some other thickness between 250 micrometers (µm) and 500 micrometers (µm). In some embodiments, the sum of the first thickness T1 and the second thickness T2 may be equal to 700 micrometers (µm), may be equal to 800 micrometers (µm), or may be equal to some other thickness between 700 micrometers (µm) and 800 micrometers (µm).

In at least one embodiment, the monocrystalline layer 110 may have a resistivity less than 25 mohm·cm or in the range 15-20 mohm·cm or equal to the upper and lower ends of this range or preferably equal to 18 mohm·cm. In at least one embodiment, the polycrystalline layer 106 has a void density less than or equal to 3%.

In the embodiment of the wafer 100 as shown in Figure 1, the bonding region 108 is present between the second surface 114 of the polycrystalline layer 106 and the third surface 116 of the monocrystalline layer 110, and the bonding region 108 is a location at which the second surface 114 of the polycrystalline layer 106 is directly and physically bonded to the monocrystalline layer 110.

In some embodiments, the monocrystalline layer 110 is directly and physically bonded to the polycrystalline layer 106 by utilizing a surface activated bonding (SAB) technique. For example, in the surface activated bonding technique, the second surface 114 of the polycrystalline layer 106 and the third surface of the monocrystalline layer 116 can be bombarded by Argon (Ar) ions or neutral atoms (*e.g*., a beam of particles that may be Argon (Ar), may be neutral atoms, or may be some other similar or like type of particle or atom that may be suitable) in an ultra-high vacuum to clean and activate the second surface 114 of the polycrystalline layer 106 and the third surface 116 of the monocrystalline layer 110. After the second surface 114 of the polycrystalline layer 106 and the third surface 116 of the monocrystalline layer 110 are cleaned and activated, the second surface 114 of the polycrystalline layer 106 and the third surface 116 of the monocrystalline layer 110 are bonded spontaneously by contacting the second surface 114 of the polycrystalline layer 106 with the third surface 116 of the monocrystalline 106. This contacting of the second surface 114 of the polycrystalline layer 106 with the third surface 114 of the monocrystalline layer 110 may be done without heat treatment.

The wafer 100 further includes at least one sidewall 120 (*e.g*., cylindrical in the embodiment as shown in Figure 1) along which at least one first sidewall 120a of the polycrystalline layer 106 and at least one second sidewall 120b of the monocrystalline layer 110 are coplanar (that is points of the first sidewall 120a that are vertically aligned with points of the second sidewall 120b have a same tangent plane) and flush with each other, respectively. In other words, the at least one sidewall 120 includes and is defined by the respective sidewalls of the polycrystalline layer 106, the bonding region 108, and the monocrystalline layer 110, respectively. The bonding region 108 includes a sidewall 120c that is flush with the sidewalls 120a of the polycrystalline layer 106 and the sidewall 120b of the monocrystalline layer 110.

As discussed earlier herein, the polycrystalline layer 106 has a low resistivity, for example, a resistivity less than or equal to 2 mohm·cm (milliohm·centimeter) or a resistivity less than or equal to 1 mohm·cm (milliohm·centimeter). This low resistivity of the polycrystalline layer 106 allows for an electrical signal (*e.g.*, electrons) to pass through the polycrystalline layer 106 without being impeded by the polycrystalline layer 106 such that the electrical signal may travel faster through the polycrystalline layer 106 and may reach its destination with a higher strength than when the polycrystalline layer 106 had a high resistivity. In other words, when the on-resistance (Rₒₙ) of the polycrystalline 106 is low (*i*.*e*., low resistivity) the electrical signal will more readily and efficiently pass through the polycrystalline layer 106 without being impeded by the polycrystalline layer 106 when traveling to its destination within an electronic device (*e.g*., semiconductor package, semiconductor die, or some other similar or like electronic device in which the polycrystalline layer 106 may be present).

While not shown in Figure 1, in some alternative embodiments of the wafer 100, a silicon oxide (*e.g.,* SiO₂) layer may be present at the bonding region 108 such that the silicon oxide layer is between the polycrystalline layer 106 and the monocrystalline layer 110.

The wafer 100 has a diameter D1 that extends from opposite points along a peripheral edge of the wafer 100. The diameter D1 may be within the range from 150 to 300 millimeters (mm) and may be equal to the upper and lower ends of this range. For example, the diameter D1 may be equal to 150 mm, may be equal to 200 mm, and may be equal to 300 mm.

The wafer 100 may have some warpage, which may be some bending or bowing within the wafer 100 that may result in the second surface 114 of the polycrystalline layer 106 being slightly curved or having a slight curvature. However, while some warpage may be present in the wafer 100, the warpage in the wafer 100 is less than or equal to 75 micrometers (µm) or may be less than or equal to 45 micrometers (µm). The warpage may be measured as a distance from a center point of the wafer to a point at or near an edge of the wafer in a direction transverse to the second surface 114 of the wafer. Warpage may be considered with respect to a flatness of the levelness of the wafer 100, which may readily be seen at and along the respective surfaces of 112, 114, 116, 118, respectively.

The second surface 114 of the polycrystalline layer 106 may have a roughness less than or equal to 20 Angstrom (Å). In some embodiments, the second surface 114 of the polycrystalline layer 106 may have a roughness in the range of 1-5 Angstrom (Å) and may be equal to the lower and upper ends of this range (*e.g.,* a roughness may be equal to 1 Angstrom (Å) or may be equal to 5 Angstrom (Å)). This roughness of the second surface 114 may be obtained by polishing the second surface 114.

The third surface 116 of the monocrystalline layer 110 may have a roughness less than or equal to 20 Angstrom (Å). In some embodiments, the third surface 116 of the monocrystalline layer 110 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the third surface 116 may be obtained by polishing the third surface 116.

The fourth surface 118 of the monocrystalline layer 110 may have a roughness less than or equal to 20 Angstrom (Å). In some embodiments, the fourth surface 118 of the monocrystalline layer 110 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the fourth surface 118 may be obtained by polishing or planarizing the fourth surface 116.

In some embodiments, a roughness at the first surface 104 of the polycrystalline layer 106 may be greater than or equal to the roughness of the second surface 114 of the polycrystalline layer 106. This roughness of the first surface 104 may be obtained by polishing or planarizing the first surface 104.

The wafer 100 or a portion of the respective wafer may be present within a semiconductor package formed utilizing the wafer 100. For example, the wafer 100 may be utilized to form a vertical device that includes the wafer 100 or a portion of the wafer 100. For example, additional layers may be formed on the monocrystalline layer 110

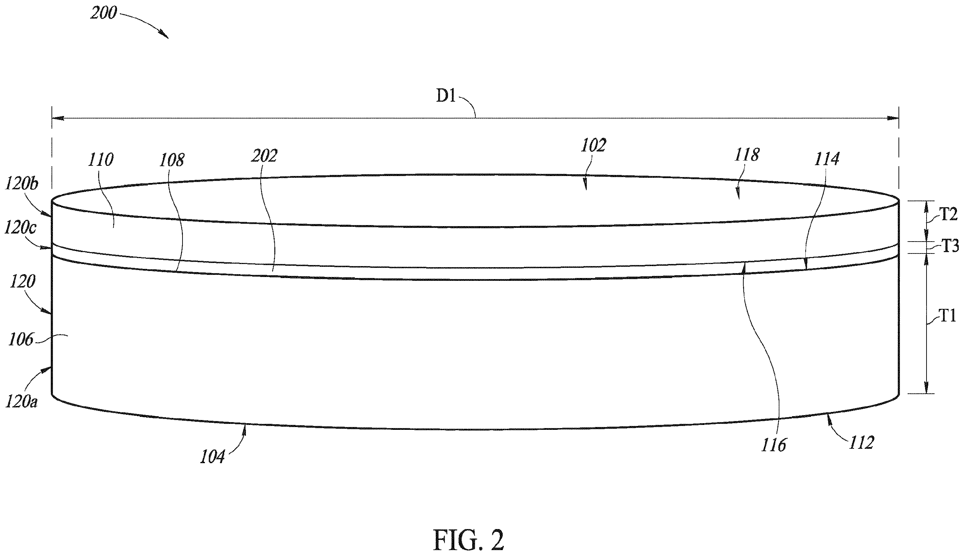

Figure 2 is directed to a perspective side view of an alternative embodiment of a wafer 200, which has several of the same or similar features as the embodiment of the wafer 100 as shown in Figure 1. The same or similar features of the wafer 200 relative to the wafer 100 have the same or similar reference numerals. Accordingly, the following discussion of the alternative embodiment of the wafer 200 as shown in Figure 2 will focus on the different or additional features or details as compared to the embodiment of the wafer 100 as shown in Figure 1.

Unlike the embodiment of the wafer 100 as shown in Figure 1 in which the second surface 114 of the polycrystalline layer 106 is directly and physically bonded to the third surface 116 of the monocrystalline layer 110, in the embodiment of a wafer 200 as shown in Figure 2 a bonding layer 202 is present at the bonding region 108 and couples together the polycrystalline layer 106 to the monocrystalline layer 110. For example, before the surface activated bonding (SAB) technique as discussed earlier herein is performed, a first conductive layer may be formed on the second surface 114 of the polycrystalline layer 106 and a second conductive layer may be formed on the third surface 116 of the monocrystalline layer 110. The first and second conductive layers may be made of the same or different conductive materials that are suitable to be bonded together utilizing the SAB technique. In some embodiments, the first and second conductive layers, respectively, may be formed on the second surface 114 of the polycrystalline layer 112 and the third surface 116 of the monocrystalline layer 110, respectively, by a sputtering technique or by some other technique suitable for forming the first and second conductive layers, respectively, on the second surface of the polycrystalline layer 112 and the third surface 116 of the monocrystalline layer 110, respectively.

After the first and second conductive layers, respectively, have been formed on the second surface 114 of the polycrystalline layer 106 and the third surface 116 of the monocrystalline layer 110, respectively, the surface activated bonding technique is performed such that the first and second conductive layers are bombarded by Argon (Ar) ions or neutral atoms (*e.g*., a beam of particles that may be Argon (Ar), may be neutral atoms, or may be some other similar or like type of particle or atom that may be suitable) in an ultra-high vacuum to clean and activate the first and second conductive layers, respectively, on the second surface 114 of the polycrystalline layer 106 and on the third surface 116 of the monocrystalline layer 110, respectively. After the first and second conductive layers are cleaned and activated, the first conductive layer on the second surface 114 of the polycrystalline layer 106 and the second conductive layer on the third surface 116 of the monocrystalline layer 110 are bonded spontaneously by contacting the first conductive layer on the second surface 114 of the polycrystalline layer 106 with the second conductive layer on the third surface 116 of the monocrystalline layer 110. This contacting of the first conductive layer on the second surface 114 of the polycrystalline layer 106 with the second conductive layer on the third surface 114 of the monocrystalline layer 110 may be done without heat treatment. Once the first conductive layer on the second surface 114 of the polycrystalline layer 106 is bonded to the second conductive layer on the third surface 116 of the monocrystalline layer 110, the bonding layer 202 between the polycrystalline layer 106 and the monocrystalline layer 110 is formed. In other words, the bonding layer 202 may be a conductive layer formed by coupling the first conductive layer on the second surface 114 to the second conductive layer on the third surface 116.

In some alternative embodiments, instead of forming both the first and second conductive layers as discussed above, only one of the first and the second conductive layers may be formed on only one of the second surface 114 of the polycrystalline layer 106 and the third surface 116 of the monocrystalline layer 110. After the first or second conductive layers is formed, the SAB technique is carried out in the same or similar fashion as discussed earlier herein either with respect to Figure 1 or Figure 2 except that the second surface 114 of the polycrystalline layer 106 or the third surface 116 of the monocrystalline layer 110 remains uncovered and is exposed to the Argon or neutral atom beam.

Either both the first and second conductive layers or one of the first and second conductive layers may be formed when a first material of the polycrystalline layer 106 is not compatible with directly and physically bonding to a second material of the monocrystalline layer 110. In other words, the first and/or second conductive layer may be formed to facilitate coupling together the polycrystalline layer 106 to the monocrystalline layer 110 when the first material of the polycrystalline layer 106 is not compatible with the second material of the monocrystalline layer 110.

When the bonding layer 202 is present between the second surface 114 of the polycrystalline layer 106 and the third surface 116 of the monocrystalline layer 110, the bonding layer 202 has a third thickness T3, which may be referred to as a third dimension. The third thickness T3 extends from the second surface 114 of the polycrystalline layer 106 to the third surface 116 of the monocrystalline layer 110. The third thickness T3 may be less than the first thickness T1. The third thickness T3 of the bonding layer 202 may be within the range from 0.2-5 micrometers (µm) and may be equal to the upper and lower ends of this range *(e.g.,* the third thickness T3 may be equal to 0.2 micrometers (µm) or may be equal to 5 micrometers (µm)). In some embodiments, the third thickness may be equal to 0.5 micrometers (µm).

The wafer 200 may have some warpage, which may be some bending or bowing within the wafer 200 that may result in the second surface 114 of the polycrystalline layer 106 being slightly curved or having a slight curvature. However, while some warpage may be present in the wafer 200, the warpage in the wafer 200 may be less than or equal to 75 micrometers (µm) or may be less than or equal to 45 micrometers (µm).

The second surface 114 of the polycrystalline layer 106 may have a roughness less than or equal to 20 Angstrom (Å). In some embodiments, the second surface 114 of the polycrystalline layer 106 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the second surface 114 may be obtained by polishing the second surface 114.

The third surface 116 of the monocrystalline layer 110 may have a roughness less than or equal to 20 Angstrom (Å). In some embodiments, the third surface 116 of the polycrystalline layer 106 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the third surface 116 may be obtained by polishing the third surface 116.

The fourth surface 118 of the monocrystalline layer 110 may have a roughness less than or equal to 20 Angstrom (Å). In some embodiments, the fourth surface 118 of the monocrystalline layer 110 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the fourth surface 118 may be obtained by polishing or planarizing the fourth surface 116.

In some embodiments, a roughness at the first surface 104 of the polycrystalline layer 106 may be greater than or equal to the roughness of the second surface 114 of the polycrystalline layer 106. This roughness of the first surface 104 may be obtained by polishing or planarizing the first surface 104.

In yet another alternative embodiment of the wafer 200, the bonding layer 202 is instead a monolayer of silicon. The monolayer of silicon includes the thickness T3 as shown in Figure 2. When the bonding layer 202 is the monolayer of silicon, the thickness T3 of the monolayer of silicon may be within a range from 0.2 nanometers (nm) to 0.7 nanometers (nm) or may be equal to the upper and lower ends of this range. The monolayer of silicon is formed the second surface 114 of the polycrystalline layer 106 when the monocrystalline layer 110 is not very compatible with being directly and physically bonded to the second surface 114 of the polycrystalline layer 106. The monolayer of silicon, which is to be the bonding layer 202, may be formed by atomic layer deposition or sputtering, resulting in the monolayer of silicon being present on the second surface 114 of the polycrystalline layer 106 such that the monocrystalline layer 110 may be readily adhered to the polycrystalline layer 106 through the monolayer of silicon, which again is the bonding layer 202. Alternatively, instead of the monolayer of silicon, the bonding layer 202 may be a monolayer of carbon, a bilayer of carbon, or a layer of silicon dioxide (SiO₂). The monolayer of carbon may have a thickness within a range from 0.4 nanometers (nm) to 2 nanometers (nm), or may be equal to the upper and lower ends of this range. The bilayer of carbon may have a thickness within a range from 1 nanometers (nm) to 5 nanometers (nm), or may be equal to the upper and lower ends of this range. The layer of SiO₂ may have a thickness within a range from 2 nm (nanometers) to 7 nm (nanometers), or may be equal to the upper and lower ends of this range.

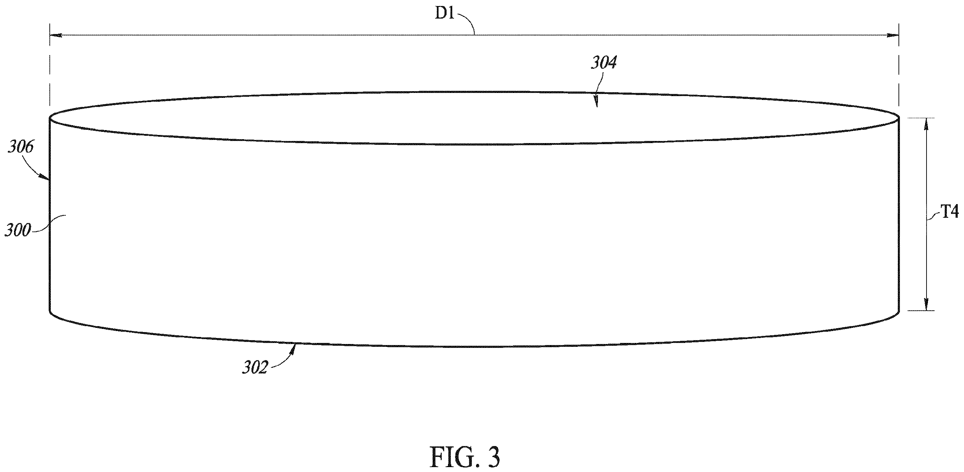

Figure 3 is a perspective side view of an embodiment of a polycrystalline substrate 300, which may be a polycrystalline wafer, before a monocrystalline substrate or wafer (*e.g.*, monocrystalline layer 110) has been coupled or bonded to the polycrystalline substrate 300. The polycrystalline substrate 300 has the diameter D1. The polycrystalline substrate 300 may be utilized in forming the polycrystalline layer 106 in wafer 100 of Figure 1 or wafer 200 of Figure 2. The polycrystalline substrate 300 includes a first surface 302, a second surface 304 opposite to the first surface 302, and a sidewall 306 that extends from the first surface 302 to the second surface 304 and is transverse to the first and second surfaces 302, 304. The second surface 304 of the polycrystalline substrate 300 may correspond to the second surface 114 of the polycrystalline layer 106 as in wafer 100 of Figure 1 or in wafer 200 of Figure 2. The sidewall 306 of the polycrystalline substrate 300 may correspond to the at least one first sidewall 120a of the polycrystalline layer 106 as in wafer 100 of Figure 1 or wafer 200 of Figure 2.

A fourth thickness T4 of the polycrystalline substrate 300 extends from the first surface 302 to the second surface 304 of the polycrystalline substrate 300. The fourth thickness T4 may be larger than or equal to the third thickness T3 of the polycrystalline layer 106 as in wafer 100 of Figure 1 and wafer 200 of Figure 2. The fourth thickness T4 may be within the range of 150 micrometers (µm) to 1000 micrometers (µm) or may be equal to the lower and upper ends of this range.

The polycrystalline substrate 300 has a low resistivity, for example, a resistivity less than or equal to 2 mohm·cm (milliohm·centimeter) or a resistivity less than or equal to 1 mohm·cm (milliohm·centimeter).

The polycrystalline substrate 300 may have some warpage, which may be some bending or bowing within the polycrystalline substrate 300 that may result in the second surface 304 of the polycrystalline layer 106 being slightly curved or having a slight curvature. However, while some warpage may be present in the polycrystalline substrate 300, the warpage in the polycrystalline substrate 300 may be less than or equal to 75 micrometers (µm) or may be less than or equal to 45 micrometers (µm).

The second surface 304 of the polycrystalline substrate 300 may have a roughness less than or equal to 20 Angstrom (Å). In some embodiments, the second surface 304 of the polycrystalline substate 300 may have a roughness in the range of 1-5 Angstrom (Å) and may be equal to the lower and upper ends of this range (*e.g.,* the roughness may be equal to 1 Angstrom (Å) or may be equal to 5 Angstrom (Å)). This roughness of the second surface 304 may be obtained by polishing the second surface 304.

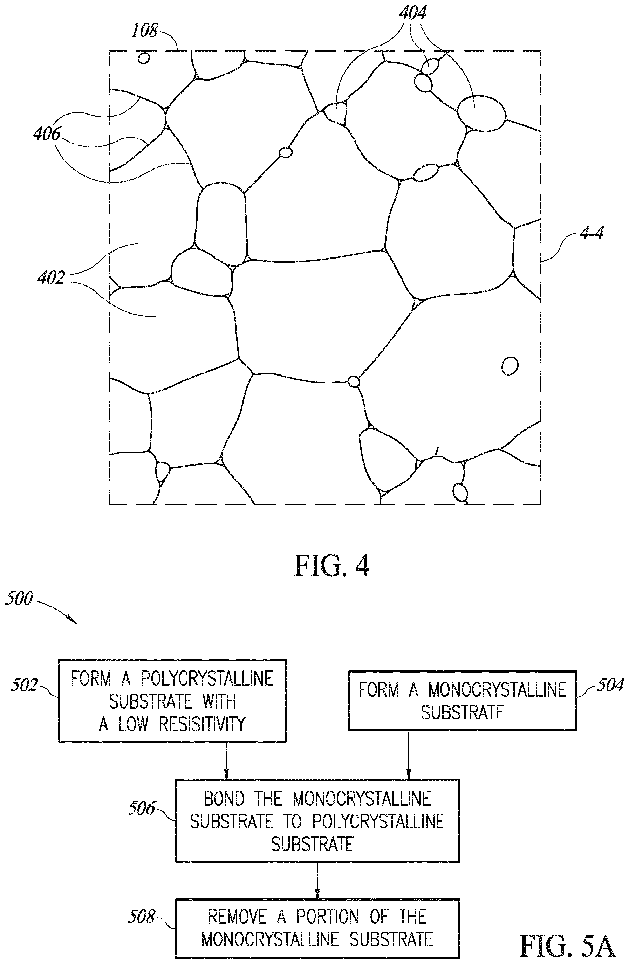

Figure 4 is a zoomed in enhanced view of section 4-4 as shown in Figure 1 of wafer 100 as shown in Figure 1. The polycrystalline layer 106 includes grains 402 of silicon carbide (*e.g.,* SiC, SiC₂, etc.) that may be bonded together (see Figure 5A of the present disclosure). This zoomed in enhanced view as shown in Figure 4 may be representative of the grain structure of the polycrystalline layer 106 in wafer 200 as shown in Figure 2 or of polycrystalline substrate 300 as shown in Figure 3.

The polycrystalline layer 106 is a non-columnar type polycrystalline such that the polycrystalline layer 106 has randomly or amorphous oriented grains and does not have a columnar type structure. This randomly and amorphous oriented grains and non-columnar structure of the polycrystalline layer 106 may be referred to as a non-oriented grain structure. This non-oriented grain structure may assist in reducing an overall resistivity of the polycrystalline layer 106.

The polycrystalline layer 106 may include micro-pores 404 that may be present along grain boundaries 406 that are between the grains 402. The grain boundaries 406 are between adjacent pairs of respective grains of the grains 402.

Carbon may be present at the grain boundaries 406 to adhere the grains 402 to each other in the polycrystalline layer 106.

The grains 402 may have a size less than or equal to 1 millimeter (mm).

The grains 402 are relatively uniform in size throughout the polycrystalline layer 106 from the first surface 112 to the second surface 114 of the polycrystalline layer 106. In other words, the grains 402 remain relatively uniform in size throughout the entirety of the polycrystalline layer 106 regardless of position along and within the polycrystalline layer 106 between the first surface 112 and the second surface 114. For example, the grain sizes of the grains 402 at the first surface 112 of the polycrystalline layer 106, at the second surface 114 of the polycrystalline layer 106, and at an intermediate position along the polycrystalline layer 106 between the first surface 112 and the second surface 114 are uniform and substantially equal to each other.

In view of the grain sizes being relatively uniform along the entirety of the polycrystalline layer 106, respective densities of the polycrystalline layer 106 at these various locations are relatively uniform and equal to each other. In other words, the polycrystalline layer 106 has a density that is relatively uniform across the entirety of the polycrystalline layer 106.

As discussed earlier herein, the polycrystalline layer 106 has a low resistivity, which may be formed utilizing the polycrystalline substrate 300. The polycrystalline layer 106 may have a low resistivity by either reducing or limiting a number of the micro-pores 404 between the grains 402 along the grain boundaries 406 such that the polycrystalline layer 106 has a resistivity less than or equal to 2 mohm·cm (milliohm·centimeter), or by having high doping of nitrogen (N) in the polycrystalline layer 106 to reduce and counter the effect of the presence of the micro-pores 404 within the polycrystalline layer 106. For example, the polycrystalline layer 106 may be doped with a high amount of nitrogen such that a concentration of nitrogen (N) that is greater than or equal to 3E+19 atoms per cm³ (*i*.*e*., 3 x 10¹⁹ atoms/cm³) in the polycrystalline layer 106 or the concentration of nitrogen in the polycrystalline layer 106 may be equal to the upper and lower ends of this range. In some embodiments, the concentration of nitrogen (N) doped within the polycrystalline layer 106 may be greater than or equal to 5E+19 atoms per cm³ (*i*.*e*., 5 x 10¹⁹ atoms/cm³).

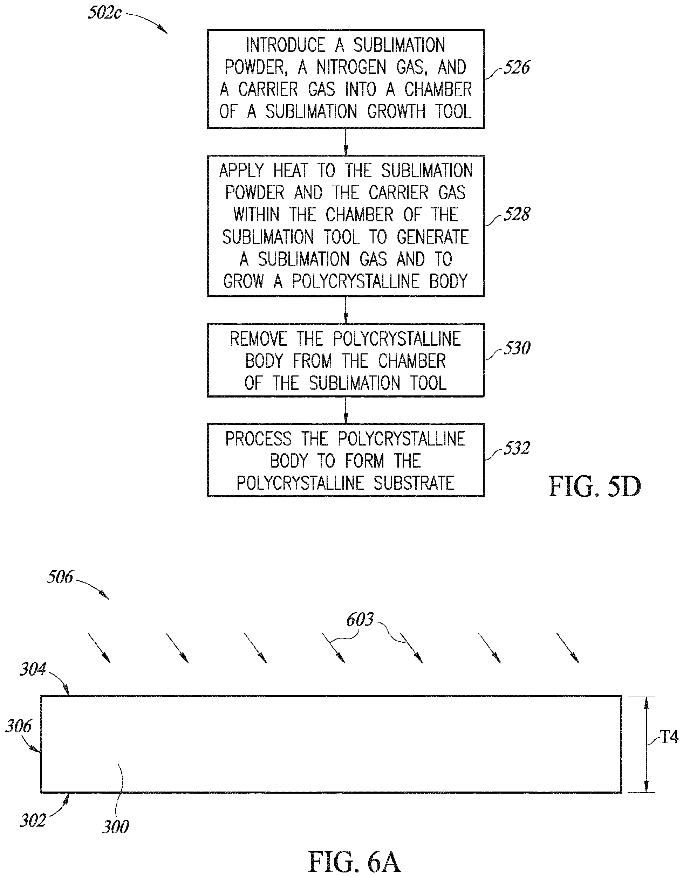

Figure 5A is directed to a flowchart 500 of an embodiment of a method of manufacturing the wafer 100 as shown in Figure 1 of the present disclosure. Figures 6A-6C are directed to side views of respective steps 502, 504, 506, 508 in the flowchart 500 of the method of manufacturing the wafer 100 of the present disclosure.

In polycrystalline substrate formation step 502, the polycrystalline substrate 300 with the low resistivity is formed. In a monocrystalline substrate formation step 504, the monocrystalline substrate 504 is formed. The polycrystalline substrate formation step 502 and the monocrystalline substrate formation step 504 may occur simultaneously within a semiconductor manufacturing plant (FAB) or may occur at different times within the FAB. The polycrystalline substrate formation step 502 and the monocrystalline substrate formation step 504 may be carried out at different locations within the FAB.

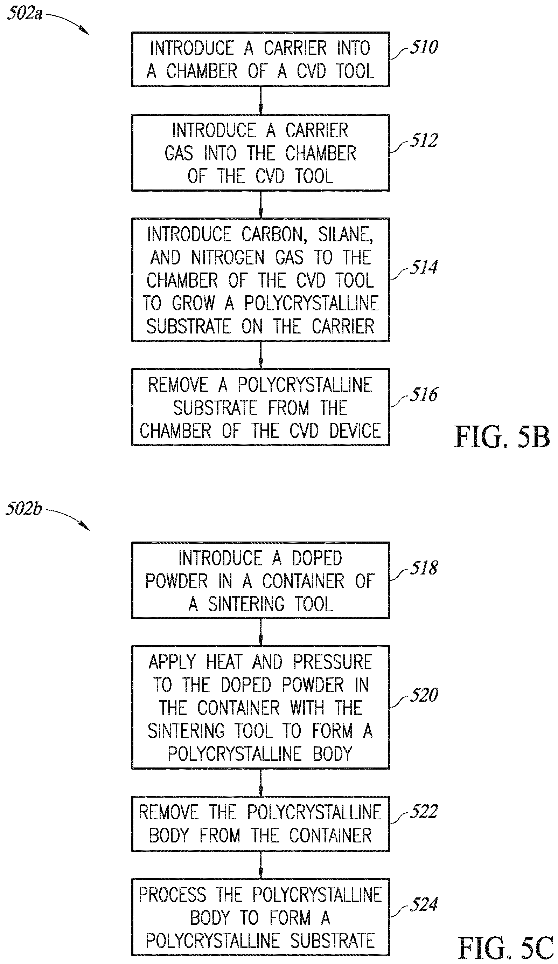

The polycrystalline substrate formation step 502 for forming the polycrystalline substrate 300 with the low resistivity may be carried out utilizing at least one of the methods of forming the polycrystalline substrate 300 as illustrated in a chemical vapor deposition (CVD) flow chart 502a as shown in Figure 5B, a sintering flowchart 502b as shown in Figure 5C, or a sublimation flowchart 502c as shown in Figure 5C. In other words, the polycrystalline substrate 300 may be formed utilizing any one of the methods in the CVD flowchart 502a, the sintering flowchart 502b, and the sublimation flowchart 502c.

When the polycrystalline substrate 300 is formed utilizing the method in the CVD flowchart 502a as shown in Figure 5B, in a first step 510, a carrier is inserted or introduced into a chamber of a CVD tool that is configured to perform or carry out a CVD process to form the polycrystalline substrate 300. The carrier may be a plate, may be a carrier substrate, or may be some other suitable type of carrier on which the polycrystalline substrate is formed. The carrier may be a polycrystalline carrier substrate or plate, may be a graphite carrier substrate or plate, or may be some other suitable type of carrier substrate or plate on which the polycrystalline substrate is formed.

After the first step 510 in which the carrier is inserted or introduced into the chamber of the CVD tool, in a second step 512, the chamber is sealed and a carrier gas is introduced into the chamber of the CVD tool. The carrier gas may be a hydrogen gas, a hydrogen base gas, an argon gas, an argon base gas, or may be some other suitable carrier gas or inert carrier gas. This carrier gas is configured to enhance a chemical reaction within the chamber of the CVD tool to grow polycrystalline silicon carbide (SiC) on the carrier within the chamber of the CVD tool. In some embodiments, during the second step 512, the chamber of the CVD tool may be heated within a range from 1500 degrees Celsius (°C) to 1700 degrees Celsius (°C) or may be heated to a temperature equal to the upper and lower ends of this range (*e.g.,* a temperature equal to 1500 degrees Celsius (°C ) or equal to 1700 degrees Celsius (°C)). In some alternative embodiments, during the second step 512, the chamber of the CVD tool may be heated within a range from 950 degrees Celsius (°C) to 1350 degrees Celsius (°C) or may be heated to a temperature equal to the upper and lower ends of this range *(e.g.,* a temperature equal to 950 degrees Celsius (°C) or equal to 1350 degrees Celsius (°C)).

After the second step 512 in which the carrier gas has been introduced into the chamber of the CVD tool and the chamber of the CVD tool has been heated or heating has been initiated, in a third step 514, a carbon gas or carbon based gas, a silicon containing gas or silicon based gas (*e.g*., silane, trichlorosilane (TCS), or some other similar silicone containing gas or silicon based gas), and a nitrogen gas or nitrogen based gas are introduced into the chamber of the CVD tool.

For example, the carbon gas or carbon based gas may be introduced into the chamber of the CVD tool by introducing a carbon source into the chamber of the CVD tool, the silicon containing gas or silicon based gas may be introduced into the chamber of the CVD tool by introducing a silicon containing gas source or silicon based gas source into the chamber of the CVD tool, and the nitrogen gas or nitrogen based gas may be introduced into the chamber of the CVD tool by introducing a nitrogen source into the chamber of the CVD tool.

Alternatively, respective fluidic pathways may be opened up that are in fluid communication with the chamber of the CVD tool to introduce the carbon gas or carbon based gas, the silicon containing gas or silicon based gas, and the nitrogen gas or nitrogen based gas.

When these respective gases are introduced into the chamber of the CVD tool at this stage, these respective gases chemically react with each other resulting in silicon carbide (SiC) doped with nitrogen being formed and deposited onto the carrier substrate resulting in polycrystalline silicon carbide forming on a carrier surface of the carrier.

When the carrier is a polycrystalline silicon carbide carrier substrate or plate, the polycrystalline silicon carbide formed by the reaction within the chamber of the CVD tool is deposited onto the polycrystalline silicon carbide carrier substrate or plate. When the carrier is a graphite carrier substrate or plate, the polycrystalline silicon carbide formed by the reaction within the chamber of the CVD tool is deposited onto the graphite carrier substrate or plate.

As the polycrystalline silicon carbide is formed in the chamber of the CVD tool, the polycrystalline silicon carbide is doped by the nitrogen resulting in polycrystalline silicon carbide doped with nitrogen being formed on the carrier.

After the third step 514 in which the carbon gas or carbon based gas, the silicon containing gas or silicon based gas, and the nitrogen gas or nitrogen based gas is introduced into the chamber of the CVD tool while being heated to form the polycrystalline silicon carbide doped with the nitrogen on the carrier, in a fourth step 516, the chamber of the CVD tool and the polycrystalline substrate 300 formed on the carrier are allowed to cool down to room temperature.

As the polycrystalline substrate 300 cools down on the carrier, differences in thermal conductivity between the polycrystalline substrate 300 and the carrier may result in some warpage in the polycrystalline substrate 300. However, this warpage of the polycrystalline substrate is less than or equal to 75 micrometers (µm) or may be less than or equal to 45 micrometers (µm).

Once cooled down to room temperature, the polycrystalline substrate 300, which is coupled to the carrier, and the carrier are removed from the chamber of the CVD tool. After the polycrystalline substrate 300 and the carrier are removed from the chamber, the polycrystalline substrate 300 may be removed from the carrier and then further processed (*e.g*., polishing techniques, planarizing techniques, etc.), a portion of the polycrystalline substrate 300 may be sliced from the polycrystalline substrate 300 to form the polycrystalline layer 106 either when coupled to the carrier or after being removed from the carrier or before or after further processing, or the polycrystalline substrate 300 may undergo other suitable types of processing techniques to further refine or process the polycrystalline substrate 300 to form various electronic device or components.

After the polycrystalline substrate 300 is formed, the polycrystalline substrate 300 may be utilized to form the wafer 100 as shown in Figure 1 or the wafer 200 as shown in Figure 2.

For example, in at least one situation, the second surface 304 of the polycrystalline layer 300 is polished or planarized such that the second surface 304 of the polycrystalline layer 300 has a roughness less than or equal to 20 Angstrom (Å). In some embodiments, the second surface 304 of the polycrystalline layer 300 has a roughness in the range of 1-5 Angstrom (Å) or has a roughness that is equal to the lower or upper ends of this range (*e.g.,* a roughness may be equal to 1 Angstrom (Å) or may be equal to 5 Angstrom (Å)). After the second surface 304 of the polycrystalline layer 300 has been polished or planarized, the polycrystalline layer 300 may then be utilized to form wafer 100 as shown in Figure 1 or wafer 200 as shown in Figure 2.

When the polycrystalline substrate 300 is formed utilizing the ₘethod in the sintering flowchart 502b as shown in Figure 5C, in a first step 518, a doped powder (*e.g*., a silicon carbide powder doped with nitrogen) is inserted or introduced into a container that may be present within a sintering tool or may be inserted or introduced into a sintering tool after being filled with the doped powder.

After the first step 518 in which the doped powder has been introduced into the container, in a second step 520, the container is then heated by the sintering tool and pressure is applied to doped powder within the container utilizing the sintering tool.

A temperature equal to or greater than 2000 degrees Celsius (°C) may be applied to the doped powder. In some embodiments, a pressure may be applied to the doped powder that is within the range of 300 millibar (mbar) to 1 ATM (1013 mbar) or equal to the lower and upper ends of this range (*e.g.,* equal to 300 mbar or equal to 1 ATM). In some embodiments, a pressure may be applied to the doped powder that is within the range of 750 millibar (mbar) to 950 millibar (mbar) or may be equal to the lower and upper ends of this range (*e.g*., equal to 750 mbar or equal to 950 mbar). Applying this temperature and pressure to the doped powder within the container utilizing the sintering tool results in forming a polycrystalline silicon carbide body doped with nitrogen in the container.

The doped powder may be doped with a dopant having a concentration of 3E+19 atoms per cm³ (*i*.*e*., 3 × 10¹⁹ atoms/cm³) or may have a concentration greater than 3E+19 atoms per cm³ (*i.e., 3* × 10¹⁹ atoms/cm³). In some embodiments, the dopant may be nitrogen (N). For example, the doped powder may be doped with the dopant having a concentration equal to 5E+19 atoms per cm³ *(i.e.,* 5 x 10¹⁹ atoms/cm³).

After the second step 520 in which the polycrystalline body has been formed in the container by applying heat and pressure to the doped powder within the container, in a third step 522, the polycrystalline body is removed from the container.

The container and the polycrystalline body may be allowed to cool down to room temperature before removing the polycrystalline body from the container. After the polycrystalline body is removed from the container, the polycrystalline body may have a cylindrical shape or profile.

After the third step 522 in which the polycrystalline body is removed from the container, in a fourth step 524, the polycrystalline body is further processed to form the polycrystalline substrate 300. For example, when the polycrystalline body removed from the container has the cylindrical shape or profile as discussed earlier herein, the polycrystalline body may be sliced down to a plurality of the polycrystalline substrates 300 as the cylindrical polycrystalline body may have a length between opposite ends of the cylindrical polycrystalline body such that the length is greater than the fourth thickness T4 such that multiple ones of the polycrystalline substrate 300 may be formed.

After the polycrystalline substrate 300 is formed, the polycrystalline substrate 300 may be utilized to form wafer 100 as shown in Figure 1 or wafer 200 as shown in Figure 2.

For example, in at least one situation, the second surface 304 of the polycrystalline layer 300 is polished or planarized such that the second surface 304 of the polycrystalline layer 300 has a roughness less than or equal to 20 Angstrom (Å). In some embodiments, the second surface 304 of the polycrystalline substate 300 may have a roughness in the range of 1-5 Angstrom (Å) or has a roughness that is equal to the lower or upper ends of this range *(e.g.,* the roughness may be equal to 1 Angstrom (Å) or may be equal to 5 Angstrom (Å)).

After the second surface 304 of the polycrystalline layer 300 has been polished or planarized, the polycrystalline layer 300 may then be utilized to form wafer 100 as shown in Figure 1 or wafer 200 as shown in Figure 2.

When the polycrystalline substrate 300 is formed utilizing the method in the sublimation flowchart 502c as shown in Figure 5D, in a first step 526, a sublimation powder, a nitrogen gas or nitrogen based gas, and a carrier gas are introduced or inserted into a chamber of a sublimation growth tool.

After the first step 526 in which the sublimation powder, the nitrogen gas or nitrogen based gas, and the carrier gas are inserted or introduced in the chamber of the sublimation tool, in a second step 528, heat is applied to the sublimation powder, the nitrogen gas or nitrogen based gas, and the carrier gas within the chamber of the sublimation growth tool. A temperature of the chamber of the sublimation tool may be in the range of 2000-2500 degrees Celsius (°C) or may be equal to the lower and upper ends of this range *(e.g.,* a temperature equal to 2000 degrees Celsius (°C) or equal to 2500 degrees Celsius (°C)). When the heat is applied to the sublimation powder, a sublimation gas is generated (*e.g.*, sublimed) from the sublimation powder. The sublimation gas generated by heating the sublimation powder reacts with the carrier gas and the nitrogen gas or nitrogen based gas resulting in a polycrystalline body made of a doped polycrystalline silicon carbide material forming and growing within the chamber of the sublimation growth tool. For example, a polycrystalline silicon carbide material may be deposited and grown on a surface within the sublimation growth tool.

After the second step 528 in which heat is applied to the sublimation powder, the nitrogen gas or nitrogen based gas, and the carrier gas within the chamber of the sublimation growth tool, in a third step 530, the polycrystalline body grown and formed within the chamber is removed from the chamber of the sublimation growth tool.

The polycrystalline body may be allowed to cool down to room temperature before being removed from the chamber of the sublimation growth tool.

After the third step 530 in which the polycrystalline body is removed from the chamber of the sublimation growth tool, in a fourth step 532, the polycrystalline body is further processed and refined to form the polycrystalline substrate 300. For example, in the fourth step 532 of the sublimation flowchart 502c, the polycrystalline body may be further refined or processed in the same or similar manner as discussed earlier herein with respect to the further processing or refining the polycrystalline body in the fourth step 524 of the sintering flowchart 502b. However, in some alternative embodiments, the polycrystalline body may already be in the form of the polycrystalline substrate 300 such that the polycrystalline body that is removed from the chamber of the sublimation growth tool is already in the form of the polycrystalline substrate 300.

After the polycrystalline substrate 300 is formed, the polycrystalline substrate 300 may be utilized to form wafer 100 as shown in Figure 1 or wafer 200 as shown in Figure 2. For example, in at least one situation, the second surface 304 of the polycrystalline layer 300 is polished or planarized such that the second surface 304 of the polycrystalline layer 300 has a roughness less than or equal to 20 Angstrom (Å).

In some embodiments, the second surface 304 of the polycrystalline substate 300 may have a roughness in the range of 1-5 Angstrom (Å) or has a roughness that is equal to the lower or upper ends of this range *(e.g.,* the roughness may be equal to 1 Angstrom (Å) or may be equal to 5 Angstrom (Å)).

After the second surface 304 of the polycrystalline layer 300 has been polished or planarized, the polycrystalline layer 300 may then be utilized to form wafer 100 as shown in Figure 1 or wafer 200 as shown in Figure 2.

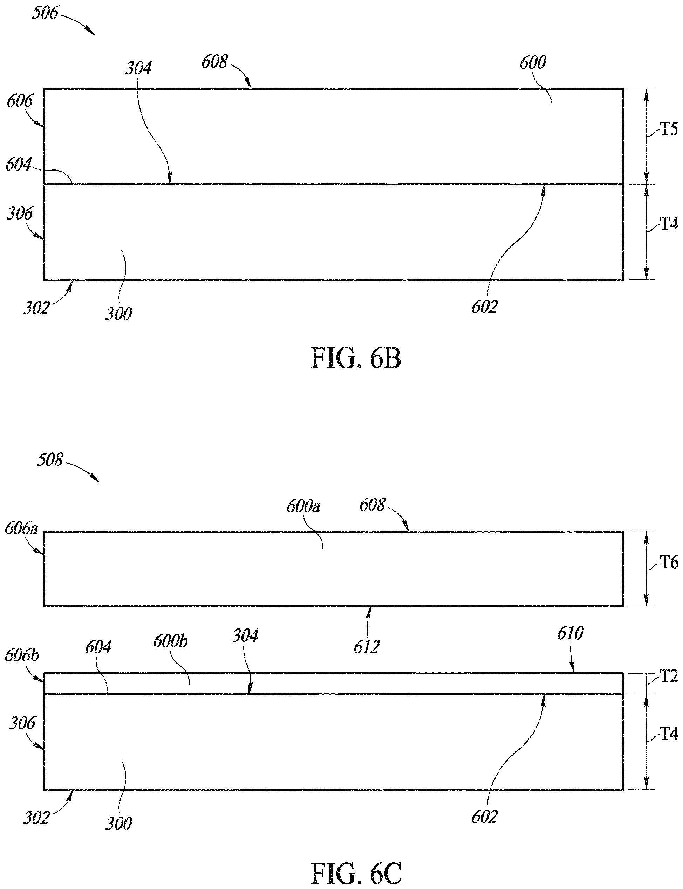

In the monocrystalline substrate formation step 504, a monocrystalline substrate 600 (see Figure 6B) may be formed utilizing a method known within the semiconductor industry. For example, the monocrystalline substrate may be formed by melting high-purity, semiconductor-grade silicon and then utilizing a seed crystal to initiate formation of the monocrystalline substrate.

Once the polycrystalline substrate 300 and the monocrystalline substrate 600 are formed, in a couple or bond step 506 of the flowchart 500 to form wafer 100 of Figure 1, the second surface 304 of the polycrystalline substrate 300 is bonded to a third surface 602 of the monocrystalline substrate 600 utilizing a surface activated bonding (SAB) technique. The third surface 602 of the monocrystalline substrate 600 may correspond to the third surface 116 of the monocrystalline layer 110 of the wafer 100.

When the SAB technique is utilized, the second surface 304 of the polycrystalline substrate 300 is exposed to a beam of neutral atoms or Argon (Ar) atoms as represented by arrows 603 in Figure 6A to activate and clean the second surface 304 of the polycrystalline substrate 300.

The second surface 304 of the polycrystalline substrate 300 may have been planarized to be substantially flat and level as well as polished to have a roughness less than or equal to 20 Angstrom (Å). In some embodiments, the second surface 304 of the polycrystalline substate 300 may have a roughness in the range 1-5 Angstrom (Å) or equal to the lower and upper ends of this range *(e.g.,* a roughness may be equal to 1 Angstrom (Å) or may be equal to 5 Angstrom (Å)) before being exposed to the beam of neutral atoms or Argon (Ar) atoms.

When the SAB technique is utilized, the third surface 602 of the monocrystalline substrate 600 is exposed to a beam of neutral atoms or Argon (Ar) atoms (not shown) to activate and clean the third surface 602 of the monocrystalline substrate 600. The third surface 602 of the monocrystalline substrate 600 may have been planarized to be substantially flat and level as well as polished to have a roughness less than or equal to 20 Angstrom (Å). In some embodiments, the third surface 602 of the monocrystalline substrate 600 may have a roughness in the range of 1-5 Angstrom (Å) or equal to the lower and upper ends of this range *(e.g.,* a roughness may be equal to 1 Angstrom (Å) or may be equal to 5 Angstrom (Å)) before being exposed to the beam of neutral atoms or Argon (Ar) atoms.

The fifth surface 610 of second portion 600b of the monocrystalline substrate 600 may have a roughness less than or equal to 20 Angstrom (Å). In some embodiments, the fifth surface 610 of the second portion 600b of the monocrystalline substrate 600 may have a roughness in the range of 1-5 Angstrom (Å) and may be equal to the lower and upper ends of this range *(e.g.,* the roughness may be equal to 1 Angstrom (Å) or may be equal to 5 Angstrom (Å)). This roughness of the fifth surface 610 of the second portion 600b may be obtained by polishing or planarizing the fifth surface 610 of the second portion 600b.

In some embodiments, a roughness at the first surface 302 of the polycrystalline substrate 300 may be greater than or equal to the roughness of the second surface 304 of the polycrystalline substrate 300. This roughness of the first surface 302 may be obtained by polishing or planarizing the first surface 302.

After the second surface 304 of the polycrystalline substrate 300 and the third surface 602 of the monocrystalline substrate 600 are cleaned and activated, the monocrystalline substrate 600 is flipped and the third surface 602 of the monocrystalline substrate 600, which is clean and activated, is contacted with the second surface 304 of the polycrystalline substrate 300, which is clean and activated, such that the clean and activated second surface 304 bonds with the clean and activated third surface 602 of the monocrystalline substrate 600 spontaneously resulting in the monocrystalline substrate 600 being bonded to the polycrystalline substrate 300 at a bonding region 604.

When the monocrystalline substrate 600 is bonded to the polycrystalline substrate 300, a sidewall 606 of the monocrystalline substrate 600 is flush with the sidewall 306 of the polycrystalline substrate 300.

The monocrystalline substrate 600 has a fifth thickness T5 that extends from the third surface 602 of the monocrystalline substrate 600 to a fourth surface 608 of the monocrystalline substrate 600 opposite to the third surface 602 of the monocrystalline substrate 600.

After the bonding step 506 in which the monocrystalline substrate 600 is bonded to the polycrystalline substrate 300, in a removal step 508, a first portion 600a is removed from a second portion 600b of the monocrystalline substrate 600. The first portion 600a may be removed from the second portion 600b by slicing the monocrystalline substrate 600 forming the first portion 600a and the second portion 600b.

After the second portion 600b has been removed from the first portion 600a, the second portion 600b of the monocrystalline substrate 600 may be utilized again to form another wafer that is the same or similar to the wafer 100 by, for example, carrying out the bonding step 506 and the removal step 508 of the method of manufacturing in the flowchart 500.

Removing the first portion 600a from the second portion 600b results in the sidewall 606 being broken up into a first sidewall 606a of the first portion 600a and a second sidewall 606b of the second portion 600b. After the first portion 600a is removed, the second sidewall 606b of the second portion 600b remains flush with the sidewall 306 of the polycrystalline substrate 300. After the first portion 600a is removed, the second portion 600b remains bonded to the polycrystalline substrate 300 at the bonding region 604.

After the first portion 600a is removed from the second portion 600b, the second portion 600b has the second thickness T2 that extends between the third surface 602 of the monocrystalline substrate 600 (now forming a third surface 602 of the second portion 600b) and a fifth surface 610 of the second portion 600b formed by removing the first portion 600a from the second portion 600b. After the first portion 600a is removed from the second portion 600b, the first portion 600a has a sixth thickness T6 that extends from the fourth surface 608 of the monocrystalline substrate 600 to a sixth surface 612 of the first portion 600a that is opposite to the fourth surface of the first portion 600a. The sixth thickness T6 is less than the fifth thickness T5.

The second portion 600b of the monocrystalline substrate 600 may correspond to the monocrystalline layer 110 of the wafer 100, the polycrystalline substrate 300 may correspond to the polycrystalline layer 106 of the wafer 100, and the bonding region 604 may correspond to the bonding region 108 of the wafer 100. In other words, in some embodiments, after the first portion 600a is removed from the second portion 600b, the wafer 100 has been manufactured.

In some alternative embodiments, some further processing steps such as grinding the first surface 302 of the polycrystalline substrate 300 may be performed to complete the manufacturing of the wafer 300.

As the monocrystalline substrate 600 is generally more expensive to manufacture relative to the polycrystalline substrate 300, bonding the monocrystalline substrate 600 to the low resistivity polycrystalline substrate 300 as a support and removing the first portion 600a from the second portion 600b reduces manufacturing costs as the monocrystalline substrate 600 may be utilized to form multiple ones of the wafers 100. In other words, while the cost of manufacturing the monocrystalline substrate may be expensive, the expense of manufacturing the monocrystalline substrate 600 may be spread out over multiple ones of the wafers 100 that are manufactured utilizing the method of manufacturing as in the flowchart 500.

In an alternative embodiment of the method of manufacturing in the flowchart 500, the first portion 600a of the monocrystalline substrate 600 may be removed from the second portion 600b of the monocrystalline substrate 600 before bonding the monocrystalline substrate 600 to the polycrystalline substrate 300. After the first portion 600a has been removed from the second portion 600b, the third surface 602 of the second portion 600b of the monocrystalline substrate 600 is bonded to the second surface 304 of the polycrystalline substrate 300. In other words, the removal step 508 occurs before the bonding step 506 in this alternative embodiment of the method of manufacturing the wafer 100.

While the above method as discussed in detail with respect to the flowchart 500 in Figure 5A describes forming the wafer 100, the above method as discussed in detail with respect to the flowchart 500 in Figure 5A could be modified by forming a first conductive layer on the second surface 304 of the polycrystalline substrate 300 with a sputtering technique, forming a second conductive layer on the third surface 602 of the monocrystalline substrate 600, or forming only one of the first and second conductive layers, and then utilizing both the first conductive layer or the only one of the first or second conductive layers to couple the polycrystalline substrate 300 to the monocrystalline substrate 600. This sputtering step may be performed or carried out between the first and second steps 502, 504 of the method as discussed in detail with respect to the flowchart 500 in Figure 5A. When this sputtering step is performed or carried out, the bonding layer 202 as shown in Figure 2 is formed resulting in the manufacturing of the alternative embodiment of the wafer 200.

While the above method as discussed in detail with respect to the flowchart 500 in Figure 5A describes forming the wafer 100, the above method as discussed in detail with respect to the flowchart 500 in Figure 5A could be modified by forming the monolayer of silicon, the bilayer of carbon, the monolayer of carbon, or the layer of silicon dioxide (SiO₂) on the second surface 304 of the polycrystalline substrate 300. After one of these respective layers of material is formed on the second surface 304 of the polycrystalline substrate 300, in at least one embodiment, the respective layer of material on the second surface 304 of the polycrystalline layer is exposed to the beam of neutral atoms or Argon (Ar) atoms as represented by arrows 603.

While not shown, the wafer 100 as shown in Figure 6C may be further processed and refined *(e.g.,* further layers *(e.g.,* conductive and non-conductive) formed on the monocrystalline layer 110, singulation of the wafer 100, back grinding wafer 100, etc.) to be utilized in forming electronic devices and components such as, for example, semiconductor packages or semiconductor devices. For example, a first electrode may be formed on the first side 104 of the wafer 100 and a second electrode may be formed on the second side 106 of the wafer 100 such that an electrical current may pass through the wafer 100 and the wafer 100 having the low resistivity allows for an electrical signal to pass through the wafer 100 without being impeded.

Examples of the present disclosure are the following:
1. A device, comprising:
   a polycrystalline silicon carbide (SiC) wafer with a resistivity less than or equal to 2 mohm·cm (milliohm·centimeter), and the polycrystalline silicon carbide includes a first surface having a roughness less than or equal to 20 Angstrom (Å); and
   a monocrystalline silicon carbide (SiC) wafer coupled to the first surface of the polycrystalline silicon carbide (SiC) wafer.
2. The device of example 1, further comprising a bonding layer on the first surface of the polycrystalline silicon carbide (SiC) wafer.
3. The device of example 2, wherein the monocrystalline silicon carbide (SiC) wafer is on the bonding layer on the surface of the polycrystalline silicon carbide (SiC) wafer and is coupled to the first surface of the polycrystalline silicon carbide (SiC) wafer by the bonding layer.
4. The device of example 3, wherein:
   the polycrystalline silicon carbide (SiC) wafer includes:
      a second surface opposite to the first surface of the polycrystalline silicon carbide (SiC) layer; and
      a first dimension that extends from the second surface to the first surface;
   the monocrystalline silicon carbide (SiC) wafer includes:
      a third surface that faces the first surface of the polycrystalline silicon carbide (SiC) wafer;
      a fourth surface that faces away from third surface and is opposite to the third surface; and
      a second dimension that extends from the third surface to the fourth surface, and the second dimension is different from the first dimension.
5. The device of example 4, wherein the second dimension is less than the first dimension.
6. The device of example 5, wherein:
   the first dimension is less than 1000 µm (micrometers); and
   the second dimension is less than or equal to 1 µm (micrometers).
7. The device of example 1, wherein the monocrystalline silicon carbide (SiC) wafer is directly and physically bonded to the first surface of the polycrystalline silicon carbide (SiC) wafer.
8. The device of example 1, wherein the resistivity is less than or equal to 1 mohm·cm (milliohm·centimeter).
9. The device of example 1, wherein a warpage of the polycrystalline silicon carbide (SiC) wafer is less than 75-µm (micrometers).
10. The device of example 8, wherein the warpage of the polycrystalline silicon carbide (SiC) wafer is less than 45-µm (micrometers).
11. The device of example 1, wherein the polycrystalline silicone-carbide (SiC) wafer has a non-columnar structure.
12. The device of example 1, wherein the polycrystalline silicone-carbide (SiC) wafer includes grains that are less than or equal to 1 mm (millimeter).
13. A device, comprising:
   a substrate including:
      a polycrystalline silicon carbide (SiC) layer including:
         a first surface;
         a second surface opposite to the first surface;
         a first dimension that extends from the first surface to the second surface; and
         a resistivity less than or equal to 2 mohm·cm (milliobm·centimeter);
      a monocrystalline silicon carbide (SiC) layer coupled to the second surface of the polycrystalline silicon carbide (SiC) layer including:
         a third surface on the second surface of the polycrystalline silicon carbide (SiC) layer;
         a fourth surface opposite to the third surface; and
         a second dimension extending from the third surface to the fourth surface, the third surface of the monocrystalline silicon carbide (SiC) layer is on a bonding layer and faces towards the first surface of the polycrystalline silicon carbide (SiC) layer, and the second dimension is less than the first dimension.
14. The device of example 13, wherein the polycrystalline silicone-carbide (SiC) layer includes grains that are less than or equal to 1 mm (millimeter).
15. The device of example 13, wherein the polycrystalline silicon carbide (SiC) layer has a non-columnar structure.
16. A device, comprising:
   a polycrystalline silicon carbide substrate including:
      a first surface;
      a second surface opposite to the first surface;
      a thickness that extends from the first surface to the second surface, the thickness being greater than or equal to 150 µm (micrometer);
      a resistivity less than or equal to 2 mohm·cm (milliohm·centimeter); and
      a warpage less than 75 µm.
17. The device of example 16, wherein the resistivity is less than or equal to 1 mohm·cm (milliohm·centimeter).
18. The device of example 16, wherein the polycrystalline silicon carbide (SiC) substrate includes grains that are less than or equal to 1 mm (millimeter) and has a non-columnar structure.
19. The device of example 16, wherein the warpage is less than or equal to 75 µm (micrometers).
20. The device of example 16, wherein the thickness is at least one of the following of between 150-1000 µm (micrometers), equal to 150 µm (micrometers), and equal to 1000 µm (micrometers).
21. A method, comprising:
   forming a polycrystalline silicon carbide (SiC) substrate with a resistivity less than or equal 2 mohm·cm (milliohm·centimeter);
   forming a monocrystalline silicon carbide (SiC) substrate; and
   coupling the monocrystalline SiC substrate to the polycrystalline SiC substrate.
22. The method of example 21, further comprising:
   removing a first portion of the monocrystalline SiC substrate from the monocrystalline SiC substrate leaving a second portion of the monocrystalline SiC substrate coupled to the polycryaslline SiC substrate.
23. The method of example 22, wherein the second portion of the monocrystalline SiC substrate have a thickness within the range of 0.3-2 micrometers (µm), equal to 0.3 micrometers (µm), or equal to 2 micrometers (µm).
24. The method of example 21, wherein the polycrystalline SiC substrate is formed on a carrier within a chemical vapor deposition (CVD) chamber of a CVD tool by introducing a silicon containing gas.
25. The method of example 24, wherein the polycrystalline SiC substrate is formed on the carrier within the CVD chamber of the CVD tool by introducing a carbon gas and a nitrogen gas.
26. The method of example 21, wherein the polycrystalline SiC substrate is formed by introducing a doped powder into a container of a sintering tool and sintering the doped powder within the container with the sintering tool.
27. The method of example 26, wherein sintering the doped powder includes exposing the doped powder to a temperature greater than or equal to 2000 degrees Celsius (C).
28. The method of example 21, wherein the polycrystalline SiC substrate is formed with a sublimation process.
29. The method of example 21, wherein coupling the monocrystalline SiC substrate to the polycrystalline SiC substrate further includes directly and physically coupling a first surface of the monocrystalline SiC substrate to a second surface of the polycrystalline SiC substrate.

While the disclosure has been made with respect to a limited number of embodiments, those skilled in the art, having benefit of this disclosure, will appreciate that other embodiments can be envisioned that do not depart from the scope of the disclosure as defined by the attached claims.

## Claims

1. A semiconductor wafer, comprising:
a polycrystalline silicon carbide -SiC- wafer (106) with a resistivity less than or equal to 2 mohm·cm, the polycrystalline silicon carbide including a first surface (114) having a roughness less than or equal to 20 Å; and
a monocrystalline silicon carbide wafer (110) coupled to the first surface (114) of the polycrystalline silicon carbide wafer (106).

2. The device of claim 1, further comprising a bonding region (108; 202) on the first surface (114) of the polycrystalline silicon carbide wafer (106).

3. The device of claim 2, wherein the monocrystalline silicon carbide wafer (110) is on the bonding layer (108; 202) on the first surface (114) of the polycrystalline silicon carbide wafer (106) and is coupled to the first surface of the polycrystalline silicon carbide wafer by the bonding layer.

4. The device of claim 3, wherein:
the polycrystalline silicon carbide wafer or layer (106) includes:
a second surface (112) opposite to the first surface (114) of the polycrystalline silicon carbide wafer (106); and
a first dimension (T1) that extends from the second surface (112) to the first surface (114) of the polycrystalline silicon carbide wafer (106);
the monocrystalline silicon carbide wafer or layer (110) includes:
a third surface (116) that faces the first surface (114) of the polycrystalline silicon carbide wafer;
a fourth surface (118) that faces away from third surface and is opposite to the third surface of the polycrystalline silicon carbide wafer; and
a second dimension (T2) that extends from the third surface to the fourth surface of the polycrystalline silicon carbide wafer, and the second dimension is different from the first dimension.

5. The device of claim 4, wherein the second dimension (T2) is less than the first dimension (T1).

6. The device of claim 5, wherein:
the first dimension (T1) is less than 1000 µm, preferably is greater than or equal to 150 µm; and
the second dimension (T2) is less than or equal to 1 µm.

7. The device of any of the preceding claims, wherein the monocrystalline silicon carbide wafer (110) is directly and physically bonded to the first surface (114) of the polycrystalline silicon carbide wafer (106).

8. The device of any of the preceding claims, wherein the resistivity is less than or equal to 1 mohm·cm.

9. The device of any of the preceding claims, wherein a warpage of the polycrystalline silicon carbide wafer is less than 75-µm, , preferably less than 45-µm.

10. The device of any of the preceding claims, wherein the polycrystalline silicone-carbide wafer has a non-columnar structure and includes grains that are less than or equal to 1 mm.

11. A method for manufacturing a semiconductor device, comprising:
forming a polycrystalline silicon carbide -SiC- substrate (106; 600) with a resistivity less than or equal 2 mohm·cm;
forming a monocrystalline silicon carbide -SiC- substrate (110; 300); and
coupling the monocrystalline SiC substrate to the polycrystalline SiC substrate.

12. The method of the preceding claim, further comprising:
removing a first portion (600a) from the monocrystalline SiC substrate (600) leaving a second portion (600b) of the monocrystalline SiC substrate coupled to the polycrystalline SiC substrate (300).

13. The method of claim 11, wherein the polycrystalline SiC substrate (106) is formed on a carrier within a chemical vapor deposition chamber of a CVD tool by introducing a silicon containing gas, a carbon gas and a nitrogen gas.

14. The method of claim 11, wherein the polycrystalline SiC substrate (106) is formed by introducing a doped powder into a container of a sintering tool and sintering the doped powder within the container with the sintering tool, by exposing the doped powder to a temperature greater than or equal to 2000°C.

15. The method of claim 11, wherein the polycrystalline SiC substrate (106) is formed with a sublimation process.
